Europäisches Patentamt

(19) European Patent Office

Office européen des brevets

(11) Numéro de publication : **0 161 998**
**B1**

(12) **FASCICULE DE BREVET EUROPÉEN**

(45) Date de publication du fascicule du brevet :
07.09.88

(51) Int. Cl.⁴ : **B 23 D 47/04,** B 23 Q   1/14,
B 23 Q 16/02

(21) Numéro de dépôt : **85440010.8**

(22) Date de dépôt : **15.02.85**

(54) **Machine à scier les contours de plaques.**

(30) Priorité : 17.02.84 FR 8402636

(43) Date de publication de la demande :
21.11.85 Bulletin 85/47

(45) Mention de la délivrance du brevet :
07.09.88 Bulletin 88/36

(84) Etats contractants désignés :
AT BE CH DE GB IT LI LU NL SE

(56) Documents cités :
AT-B-   354 720
DE-B- 1 172 929
FR-A- 2 182 891
GB-A- 1 030 262
US-A- 3 054 224
US-A- 3 158 920
LA MACHINE MODERNE, volume 57, novembre 1963,
pages 21-22, Paris, FR; A.N. RABINOVITCH: "Automatisation des procédés de fabrication en construction mécanique"

(73) Titulaire : SMID S.A., Société Anonyme dite:
54, rue Poincaré
F-68460 Lutterbach (FR)

(72) Inventeur : Erhard, Raymond
6, rue de la Carrière
F-68760 Willer-Sur-Thur (FR)

(74) Mandataire : Aubertin, François
Cabinet Lepage & Aubertin Innovations et Prestations 4, rue de Haguenau
F-67000 Strasbourg (FR)

## Description

L'invention concerne une machine à scier des produits commercialisés sous forme de plaques, ces plaques étant métalliques, en bois, en particules ou autres matériaux analogues et mises à dimensions par un sciage par le dessous.

Différents produits métalliques, en bois, en particules ou autres matériaux analogues demandent, en sortie de fabrication, une mise à la dimension aussi bien dans le sens de la largeur que dans le sens de la longueur avant de pouvoir être commercialisés. A cet effet, il est nécessaire de scier le contour de ces plaques. Fréquemment, cette mise à la dimension doit être réalisée d'une manière très précise, notamment lorsque ces plaques sont destinées à la fabrication de circuits imprimés.

On connaît déjà différents dispositifs permettant cette mise à dimension de ces plaques.

On connaît par le document FR-A-2.182.891 un dispositif se composant de deux machines à scier, l'une effectuant la coupe en long pour la mise en largeur et l'autre effectuant la coupe en travers pour la mise en longueur de la plaque. Entre ces deux machines à scier est disposée une table de transfert conférant à la plaque un acheminement perpendiculaire au précédent. Après mise en place sur une table d'alimentation, les plaques sont présentées par l'un de leurs bords longitudinaux devant la lame de scie de la première machine. Après coupe, les plaques sont soumises à un déplacement de sorte que leur second bord longitudinal se présente devant la même machine permettant d'obtenir des plaques à la largeur voulue. Puis, on déplace les plaques pour les amener sur la table de transfert. Celle-ci présente successivement les bords transversaux des plaques devant la lame de scie de la seconde machine. Après mise en longueur, les plaques sont dégagées du dispositif. L'inconvénient majeur de ce dispositif réside dans la complexité de l'installation. En effet, le chargement et le déchargement se réalisent à deux endroits différents, ce qui nécessite plusieurs manipulateurs.

Un autre dispositif connu comporte une seule machine à scier permettant le sciage par le dessous de la plaque. On procède d'abord à la coupe des deux bords longitudinaux pour obtenir la largeur prédéterminée puis on implique manuellement une rotation d'un quart de tour à la plaque pour la coupe des deux bords transversaux pour la mise en longueur de la plaque. L'inconvénient majeur de ce dispositif réside dans la manipulation manuelle des plaques.

Un autre dispositif connu comporte une machine à portique permettant de scier par le dessus lesdites plaques. Il existe différentes machines à portique, soit elles comportent une poutre mobile à tête orientable et à mouvement croisé, soit elles comportent deux poutres à déplacement parallèle, soit elles présentent deux machines transfert à deux poutres, l'une pour la coupe en long et l'autre la coupe en travers. La surface des plaques étant variable, l'emplacement du sciage n'est pas toujours au même endroit et varie en fonction de ladite surface. De ce fait, il est difficile de pourvoir cette machine à portique d'un dispositif permettant l'évacuation automatique des chutes. Ainsi, lesdites chutes doivent être enlevées manuellement.

La présente invention a pour but de remédier à ces inconvénients. L'invention, telle qu'elle est caractérisée dans la revendication 1, résout le problème consistant à créer une machine à scier des produits commercialisés sous forme de plaques, ces plaques étant métalliques, en bois, en particules ou autres matériaux analogues et mises à dimensions par un sciage par le dessous, comportant un plateau tournant monté sur une table d'alimentation à positionnement variable perpendiculairement à la ligne de sciage et soumise à un mouvement d'avance et de recul, ce dernier provoquant la rotation d'un quart de tour du plateau tournant.

Les avantages obtenus grâce à cette invention consistent essentiellement en ce que la machine présente les avantages d'une machine à scier par le dessous tout en permettant d'éliminer la manipulation manuelle des plaques et l'enlèvement manuel des chutes. Par ailleurs, cette machine est une machine unique de faible encombrement dont le chargement et le déchargement s'effectuent au même endroit. De ce fait, un seul manipulateur suffit. De plus, elle présente une très grande précision de coupe puisque le positionnement de la table pour la coupe longitudinale et pour la coupe transversale se fait en butée positive toujours par rapport à la même lame de scie. Du fait que le trait de scie est toujours au même emplacement, il est possible de prévoir un dispositif assurant le dégagement automatique des chutes. Les revendications 2 à 9 présentent des modes préférés de réalisation de l'invention.

L'invention est exposée ci-après plus en détail à l'aide de dessins représentant seulement un mode d'exécution.

La figure 1 représente en vue en élévation, partiellement en coupe, l'ensemble plateau tournant et table à déplacement linéaire monté sur une machine à scie conforme à l'invention.

La figure 2 représente une vue en coupe selon ligne de coupe II-II de la figure 5.

La figure 3 représente une vue partielle en coupe selon ligne de coupe III-III de la figure 5.

La figure 4 représente une vue partielle en coupe selon ligne de coupe IV-IV de la figure 5.

La figure 5 représente une vue en plan de l'ensemble plateau tournant et table à déplacement linéaire.

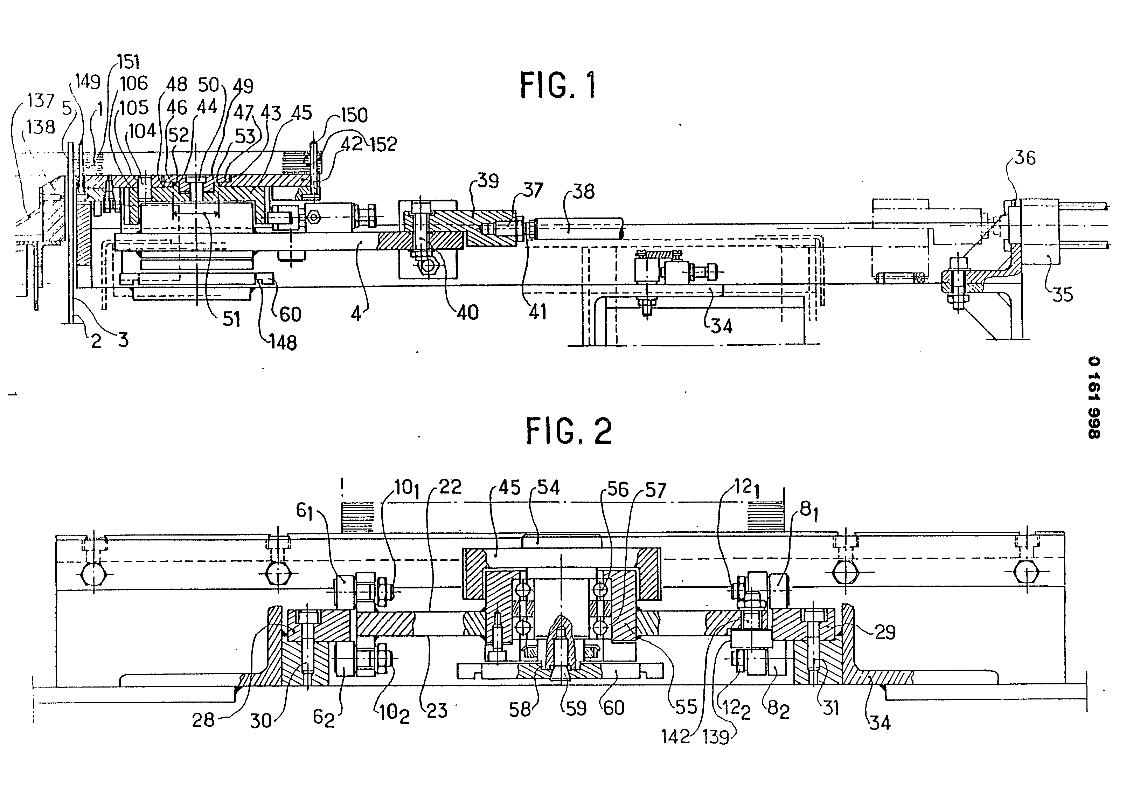

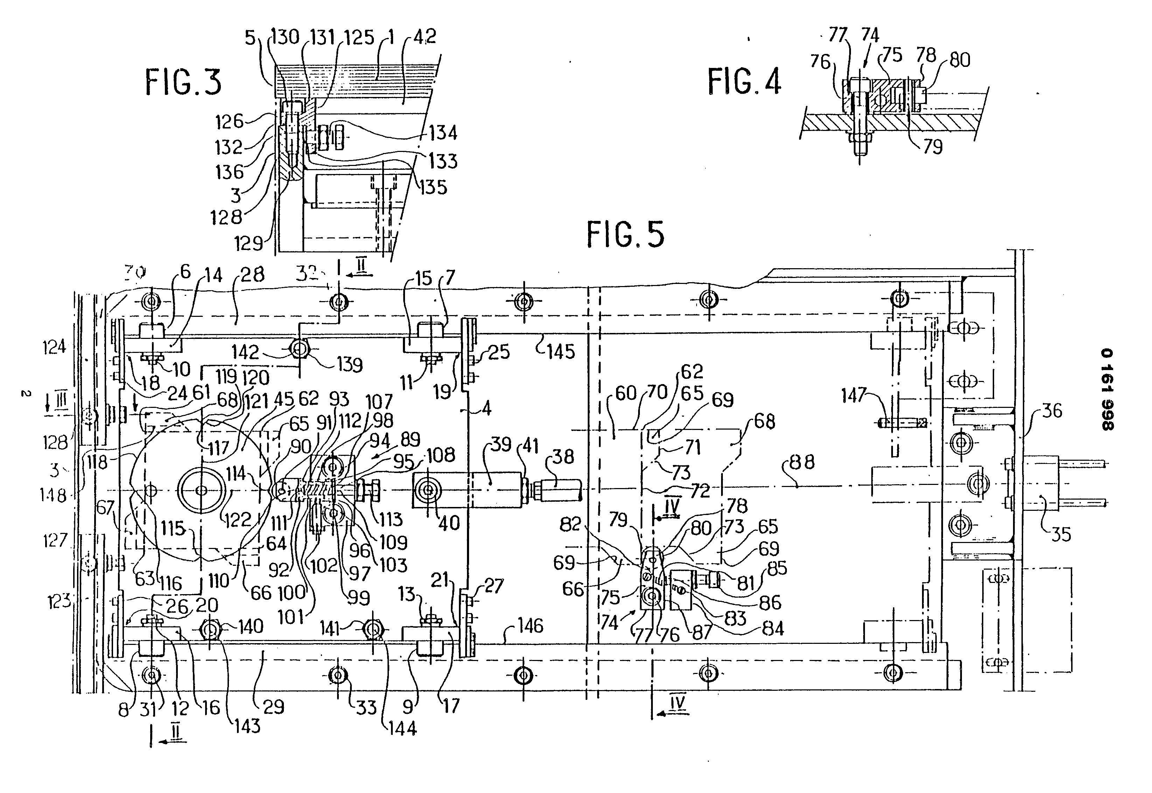

On se réfère aux figures 1, 2 et 5.

La machine à scier les quatre côtés des plaques 1, destinées notamment à la fabrication de circuits imprimés, comporte une lame de scie circulaire 2 assurant le sciage par le dessous desdites plaques 1. Celles-ci pouvant être empilées sont acheminées vers la ligne de sciage 3 par une table d'alimentation 4. Cette table d'alimentation 4 est soumise à un mouvement de va-et-vient perpendiculaire à la ligne de sciage 3 pour présenter la pile de plaques 1 à la lame de scie circulaire 2 en vue de la coupe du bord 5 et pour éloigner cette pile de plaques 1 après sciage.

A cet effet, la table d'alimentation 4 comporte des trains de galets 6, 7, 8, 9 se composant de galets supérieurs $6_1$, $7_1$...et galets inférieurs $6_2$, $7_2$.... Ces galets $6_1$, $7_1$...., $6_2$, $7_2$...pivotent autour d'un axe horizontal 10, 11, 12, 13, $10_1$, $11_1$... maintenu par des supports 14, 15, 16, 17 disposés de préférence aux quatres coins 18, 19, 20, 21 de la table d'alimentation 4. Ces supports 14, 15, 16, 17, faisant saillie par rapport à la face supérieure 22 et par rapport à la face inférieure 23 de la table d'alimentation 4, sont rendus solidaires de cette dernière par soudure. Ces supports 14, 15, 16, 17 comportent des racleurs 24, 25, 26, 27. Les trains de galets 6, 7, 8, 9 sont guidés par des rails 28, 29 maintenus par des éléments de fixation 30, 31, 32, 33 ... sur une ossature fixe 34. Ces rails 28, 29 sont disposés entre les galets supérieurs $6_1$, $7_1$... et les galets inférieurs $6_2$, $7_2$....

Par ailleurs, on prévoit pour le guidage latéral de la table d'alimentation des galets 139, 140, 141 pivotant autour d'un axe vertical 142, 143, 144 et coopérant avec le chant latéral 145, 146 des rails 28, 29.

Pour assurer le mouvement de va-et-vient de la table d'alimentation 4, la machine à scier comporte un vérin 35 de préférence hydraulique. Ce vérin 35 est solidaire d'un support 36 lui-même fixé sur l'ossature fixe 34. L'extrémité 37 du piston 38 de ce vérin 35 est solidaire d'une des extrémités d'une biellette 39 dont l'autre extrémité est rendue solidaire de la table d'alimentation 4 par un élément de fixation 40. La course de la table d'alimentation 4 peut être réglée, d'une part, par le vérin 35 et, d'autre part, par des éléments de réglage 41 permettant de modifier la position de l'extrémité 37 du piston 38 du vérin 35 par rapport à la biellette 39.

Conformément à l'invention, la table d'alimentation 4 comporte un plateau tournant 42 sur lequel sont empilées les plaques 1. Pour la fixation du plateau tournant 42, on prévoit un dispositif de verrouillage permettant l'interchangeabilité du plateau tournant 42. A cet effet, on réalise au centre du plateau tournant 42 un logement en forme de croisillon 43. Dans ce logement 43 est disposé un cliquet de verrouillage 44 assurant la fixation du plateau tournant 42 sur un flasque 45 mobile en rotation. Lorsque le cliquet de verrouillage 44 occupe la position représentée dans la figure 1, les deux ailes 46, 47 de ce cliquet 44 prennent appui sur des épaulements 48, 49 du logement 43 et il n'est pas possible de retirer par le haut ledit plateau tournant 42. Par contre, en impliquant au cliquet de verrouillage 44 une rotation d'un quart de tour autour d'un axe d'articulation 50, on annihile la coopération des ailes 46, 47 du cliquet de verrouillage 44 avec les épaulements 48, 49 du logement 43 du plateau tournant 42 et on peut retirer ce dernier. De ce fait, il est possible d'interchanger le plateau tournant 42 pour l'adapter aux dimensions des plaques 1. La largeur du cliquet de verrouillage 44 est inférieure à la distance 51 séparant les chants 52, 53 des épaulements 48, 49.

La rotation du plateau tournant 42 est rendue possible par la mise en place d'un pivot 54 solidaire en rotation du flasque 45 et pouvant tourner dans un palier 55 à roulements à billes 56, 57 solidaire de la table d'alimentation 4.

Pour la rotation automatique du plateau tournant 42 lors du recul de la table d'alimentation 4, on prévoit un dispositif de commande. Sur l'extrémité inférieure 58 du pivot 54 est disposée par un élément de fixation 59 une came d'indexation 60. Cette came d'indexation 60 a une surface carrée. Aux quatres coins 61, 62, 63, 64 la came d'indexation 60 présente des butées 65, 66, 67, 68. Chaque butée 65, 66, 67, 68 a la forme approximative d'un trapèze rectangle dont le petit côté 69 est situé dans le prolongement d'un des côtés 70 du coin 61, 62, 63, 64 de la came d'indexation 60 et dont le côté 71, perpendiculaire au petit côté 69, est relié à l'autre côté 72 du coin 61, 62, 63, 64 par une rampe inclinée 73.

Les butées 65, 66, 67, 68 coopèrent successivement avec un poussoir d'indexation 74 visible dans les figures 1, 4 et 5. Ce poussoir d'indexation 74 se compose essentiellement d'un levier 75 pivotant horizontalement par rapport à un axe d'articulation vertical 76 solidaire de l'ossature fixe 34. Cet axe d'articulation vertical 76 est situé à l'une des extrémités 77 du levier 75 alors que l'autre extrémité 78 comporte un axe vertical 79 autour duquel tourne un galet 80 prenant appui sur la came d'indexation 60. Pour assurer le contact entre le galet 80 et la came d'indexation 60, on prévoit un élément élastique 81 dont une des extrémités 82 est solidaire du levier 75 et dont l'autre extrémité 83 est solidaire d'un support 84 fixé sur l'ossature 34. Ce support 84 est traversé. par un élément réglable 85 dont l'extrémité 86 est en contact avec le chant 87 du levier 75 par suite de la traction exercée par l'élément élastique 81. Cet élément réglable 85 interdit l'effacement du galet 80 lors du recul de la table d'alimentation 4. Ce dernier assure le maintien du levier 75 en position d'action. La coopération entre la came d'indexation 60 et la poussoir d'indexation 74 provoquant la rotation d'un quart de tour du plateau tournant 42 est le suivant :

. Au cours du recul de la table d'alimentation 4, le petit côté 69 de la butée 66 vient heurter le galet 80 du levier 75. Celui-ci ne peut pivoter en arrière en raison de l'élément réglable 85 prenant appui contre son chant 87. De ce fait, on implique à la came d'indexation 60 une rotation dans le sens des aiguilles d'une montre. Le petit côté 69 de la butée 66 puis le côté 72 du coin 62 glissent le long du galet 80 jusqu'à ce que le côté 72 soit parallèle au plan médian 88 de la table d'alimentation 4 de sorte que la butée 65 vient se situer du côté du poussoir d'indexation 74.

. Au cours de l'avance de la table d'alimentation 4, la rampe inclinée 73 de la butée 65 rentre en contact avec le galet 80 qui s'efface en provoquant la rotation du levier 75 autour de son axe d'articulation vertical 76 jusqu'à ce que le galet 80 glisse sur le petit côté 69 de la butée 65. Au cours de la rotation du levier 75, on exerce une traction sur l'élément élastique 81. Lorsque la butée 65 n'est plus en contact avec le galet 80, l'élément élastique 81 ramène le levier 75 en position d'action.

Cependant, il est nécessaire qu'au cours de l'avance, le plateau tournant 42 soit immobile et ne peut pas pivoter. A cet effet, on prévoit un dispositif de blocage 89 assurant, d'une part, le positionnement angulaire du plateau tournant 42 par rapport au plan médian 88 et, d'autre part, le maintien en position du plateau tournant 42 en phase d'avance de la table d'alimentation 4.

Ce dispositif 89, solidaire de la table d'alimentation 4, comporte un galet 90 pivotant autour d'un axe 91 maintenu par une chape 92 présentant à sa partie arrière 93 un corps cylindrique 94. Celui-ci coulisse dans une douille 95 enfilée dans un logement horizontal 96 réalisé dans un support 97 rendu solidaire par des éléments de fixation 98, 99 de la face supérieure 22 de la table d'alimentation 4. Pour annihiler la rotation du corps cylindrique 94 et de la douille 95, on prévoit dans le corps cylindrique 94 une rainure longitudinale 100 dans laquelle s'engage l'extrémité 101 d'un axe 102 traversant un orifice 103 réalisé dans la douille 95. Pour assurer le contact entre le galet 90 et le pourtour du flasque 45, rendu solidaire en rotation du plateau tournant 42 par l'axe d'articulation 50 et par un axe de liaison 104 engagé, d'une part, dans un trou 105 réalisé dans le plateau tournant 42 et, d'autre part, dans un trou 106 réalisé dans le flasque 45 (voir figure 1), le support 97 comporte un élément élastique 107 permettant le déplacement de la chape 92. L'une des extrémités 108 de ce dernier prend appui contre le fond 109 du logement 96 alors que l'autre extrémité 110 prend appui contre le fond 111 d'un trou borgne 112 réalisé dans le corps cylindrique 94. La compression de l'élément élastique 107 est variable par suite de l'action d'un élément de réglage 113.

Le galet 90 s'engage dans des entailles en forme de «V» 114, 115, 116, 117 dans le pourtour 118 du flasque 45. Les deux ailes 119, 120 de chaque entaille 114, 115, 116, 117 sont perpendiculaires l'une à l'autre. Les entailles 114, 115, 116, 117 sont disposées par paire sur deux diamètres 121, 122 perpendiculaires l'un et l'autre. Ainsi, le galet 90 est en contact simultanément avec les deux ailes 119, 120 de chaque entaille 114, 115, 116, 117, ce qui provoque le blocage du flasque 45. Au cours de la rotation du plateau tournant 42, le galet 90 glisse le long du pourtour 118 du flasque 45 en comprimant l'élément élastique 107. Lorsque le galet 90 se trouve en face d'une des entailles 114, 115, 116, 117, l'élément élastique 107 se détend et force le galet 90 à rentrer dans l'entaille jusqu'à ce qu'il soit en contact avec les deux ailes 119, 120. De ce fait, on obtient un maintien du plateau tournant 42.

Du fait que les dimensions des plaques 1 doivent être précises notamment si celles-ci sont destinées à la fabrication de circuits imprimés, il est nécessaire de positionner très exactement l'ensemble table d'alimentation 4 - plateau tournant 42 par rapport à la ligne de sciage 3. A cet effet, on prévoit des butées de précision 123, 124 contre lesquelles vient heurter le chant 125 du plateau tournant 42 (voir figures 1, 3 et 5). Les butées de précision 123, 124 comportent une réglette horizontale 126 traversée verticalement par des éléments de fixation 127, 128 coopérant avec un support 129 solidaire de l'ossature fixe 34. La tête 130 de ces éléments de fixation 127, 128 est noyée dans un logement 131 pratiqué verticalement dans la réglette horizontale. Ce logement 131 aboute à un alésage 132 dont le diamètre est supérieur à celui des éléments de fixation 127, 128. Les butées de précision 123, 124 comportent également une aile verticale 133 traversée horizontalement par des éléments de réglage 134. L'extrémité avant 135 de ces éléments de réglage 134 prend appui contre la face arrière 136 du support 129. En agissant sur ces éléments de réglage 134, on provoque un déplacement horizontal, réalisé perpendiculairement par rapport à la ligne de sciage 3, des butées de précision 123, 124. Après positionnement des butées de précision 123, 124, on procède au serrage des éléments de fixation 127, 128. Ainsi, ces butées de précisions 123, 124 complètent le réglage de la course de la table d'alimentation 4.

Du fait que la ligne de sciage 3 est toujours au même emplacement, on peut pourvoir la machine à scier d'un dispositif de dégagement automatique des chutes. Ce dispositif, comme visible dans la figure 1, comporte une rampe inclinée 137 solidaire d'un support 138 placé de l'autre côté de la ligne de sciage 3 par rapport à la table d'alimentation 4. Les chutes tombent sur la rampe inclinée 137 puis sont dirigées vers un moyen d'évacuation quelconque.

Il se peut que, sous l'effet du démarrage ou du ralentissement de la course de la table d'alimentation 4, le plateau tournant 42 pivote inopinément. A cet effet, on prévoit un dispositif de sécurité constitué d'une cellule photoélectrique émettrice 147 montée sur la table d'alimentation 4 et d'une cellule photoélectrique réceptrice solidaire du bâti (non représenté). La cellule photoélectrique émettrice 147 émet un rayon à travers une fente 148 réalisée dans chaque côté de la came d'indexation 60. Cette fente 148 est strictement parallèle au plan médian 88. Si le positionnement du plateau tournant 42 n'est pas correct, le rayon ne passe plus à travers la fente 148 et la cellule photoélectrique réceptrice n'est plus sollicitée. Cette dernière agit et provoque l'arrêt de l'avance de la table d'alimentation 4.

Lors de l'empilage des plaques 1, il est nécessaire de les positionner exactement par rapport au plateau tournant 42. Celui-ci comporte des tiges de centrage 149, 150 sur lesquelles on enfile les plaques 1 présentant, comme il est connu en soi, des trous de positionnement 151, 152.

**Revendications**

1. Machine à scier des produits commercialisés sous formes de plaques, ces plaques étant métalliques, en bois, en particules ou autres matériaux analogues et mises à dimensions par un sciage par le dessous, comportant :

— une ossature fixe (34) pourvue de rails (28, 29) servant de guidage à :

— une table d'alimentation (4), à positionnement variable perpendiculairement à la ligne de sciage (3) comprenant d'une part, des trains de galets (6, 7, 8, 9) composés de galets supérieurs $(6_1, 7_1...)$ et de galets inférieurs $(6_2, 7_2...)$ pivotant autour d'un axe horizontal (10, 11, 12, 13) maintenu par des supports (14, 15, 16, 17) solidaires de la table d'alimentation (4), les rails de guidage (28, 29) de l'ossature fixe (34) étant situés entre les galets supérieurs $(6_1, 7_1...)$ et inférieurs $(6_2, 7_2...)$ et, d'autre part, un palier (55) à roulement à billes (56, 57) dans lequel tourne un pivot (54),

— un vérin (35) de préférence hydraulique, soumettant la table d'alimentation (4) à un mouvement d'avance et de recul, dont une extrémité est solidaire d'un support (36) fixé sur l'ossature (34) et dont l'extrémité (37) du piston (38) est solidaire d'une des extrémités d'une biellette (39) dont l'autre extrémité est rendue solidaire de la table d'alimentation (4) par un élément de fixation (40),

— des moyens de réglage de la course de la table d'alimentation (4) constitués, d'une part, par le vérin (35) et, d'autre part, par des éléments de réglage (41) permettant de modifier la position de l'extrémité du piston (38) du vérin (35) par rapport à la biellette (39),

— un plateau tournant (42) solidaire en rotation d'un flasque (45) par l'intermédiaire d'un axe de liaison (104) engagé, d'une part, dans un trou (105) réalisé dans le plateau tournant (42) et, d'autre part, dans un trou (106) réalisé dans le flasque (45), ce dernier étant solidaire en rotation du pivot (54) tournant dans le palier (55) de la table d'alimentation (4),

— un dispositif de commande provoquant la rotation automatique d'un quart de tour du plateau tournant (42), ce dispositif de commande actionné par le recul de la table d'alimentation (4) étant pourvu d'une came d'indexation (60) solidaire en rotation de l'extrémité inférieure (58) du pivot (54), cette came d'indexation (60) de surface carrée étant pourvue à ses quatre coins (61, 62, 63, 64) de butées (65, 66, 67, 68) ayant chacune une forme approximative d'un trapèze rectangle dont le petit côté (69), situé dans le prolongement d'un des côtés (70) du coin (61, 62, 63, 64), et dont le côté (71), perpendiculaire au petit côté (69), sont reliés à l'autre côté (72) du coins (61, 62, 63, 64) par une rampe inclinée (73).

2. Machine à scier selon la revendication 1, où le dispositif de commande comporte un poussoir d'indexation (74) agissant sur une des butées (65, 66, 67, 68) lors du recul de la table d'alimentation (4) mais s'effaçant lors de l'avance de ladite table d'alimentation (4); ce poussoir d'indexation (74) comportant, d'une part, un levier (75), pivotant horizontalement autour d'un axe d'articulation (76) solidaire de l'ossature fixe (34) disposé à l'une des extrémités (77) du levier (75) dont l'autre extrémité (78) est pourvue d'un galet (80) pivotant autour d'un axe vertical (79) et coopérant avec les butées (65, 66, 67,68) de la came d'indexation (60) et, d'autre part, un support (84) solidaire de l'ossature (34) et relié au levier (75) par un élément élastique (81) exerçant une traction sur ledit levier (75) pour le maintenir en position d'action, ce support (84) ayant un élément réglable (85) s'opposant à l'effacement du galet (80) lors du recul de la table d'alimentation (4), l'extrémité (86) de cet élément réglable (85) étant en contact avec le chant (87) du levier (75) lorsque ce dernier est en position d'action.

3. Machine à scier selon la revendication 1, comportant pour le positionnement angulaire du plateau tournant (42) et son maintien en position lors de l'avance de la table d'alimentation (4), un dispositif de blocage (89) composé, d'une part, d'un support (97) solidaire de la face supérieure (22) de la table d'alimentation (4), présentant un logement horizontal (96) dans lequel coulisse un corps cylindrique (94) d'une chape (92) pourvue d'un galet (90) pivotant autour d'un axe (91), le corps cylindrique (94), entouré d'une douille (95) ayant une rainure longitudinale (100) dans laquelle s'engage l'extrémité (101) d'un axe (102) traversant un orifice (103) réalisé dans la douille (95) et annihilant la rotation du corps cylindrique (94) et de la douille (95), et, d'autre part, d'un élément élastique (107) interposé entre le fond (109) du logement (96) et le fond (111) d'un trou borgne (112) réalisé dans le corps cylindrique (94) et assurant le rappel élastique du galet (90), ledit support (97) comportant un élément de réglage (113) pour modifier la compression de l'élément élastique (107).

4. Machine à scier selon la revendication 1, pour laquelle le flasque (45) comporte sur son pourtour (118) des entailles en forme de «V» (114, 115, 116, 117) disposées par paire sur deux diamètres (121, 122) perpendiculaires l'un à l'autre et dans lesquelles s'engage le galet (90) du dispositif de blocage (89), ces entailles (114, 115, 116, 117) ayant deux ailes (119, 120) perpendiculaires l'une à l'autre et dont la coopération simultanée avec le galet (90) assure le positionnement et le maintien en position du plateau tournant (42).

5. Machine à scier selon la revendication 1, où l'ossature fixe (34) comporte des butées de précision (123, 124) contre lesquelles vient heurter le chant (125) du plateau tournant (42), ces butées de précision (123, 124) présentant, d'une part, une réglette horizontale (126) présentant un alésage (132) supérieur au diamètre des éléments de fixation (127, 128) rendant les butées de précision (123, 124) solidaires de l'ossature fixe (34) et, d'autre part, une aile verticale (133) traversée horizontalement par des éléments de réglage (134) pour positionner les butées de précision (123, 124) par rapport au support (129) et, par voie de conséquence à la ligne de sciage (3).

6. Machine à scier selon la revendication 1, qui comporte, pour permettre l'interchangeabilité du plateau tournant (42), un dispositif de verrouillage présentant, d'une part, un logement en forme de croisillon (43) réalisé dans le plateau tournant (42) ayant deux épaulements (48, 49) et, d'autres part, un cliquet de verrouillage (44) pivotant autour d'un axe d'articulation (50) solidaire du flasque (45) du plateau tournant (42), ce cliquet de verrouillage (44) comportant deux ailes (46, 47) de longueur supérieure à la distance (51) séparant les chants (52, 53) des épaulements (48, 49) et une largeur inférieure à la distance (51) séparant les chants (52, 53) des épaulements (48, 49).

7. Machine à scier selon la revendication 1, qui comporte un dispositif de dégagement automatique des chutes constitué d'une rampe inclinée (137) solidaire d'un support (138) placé de l'autre côté de la ligne de sciage (3).

8. Machine à scier selon la revendication 1, dans laquelle la came d'indexation (60) comporte sur chaque côté une fente (148) parallèle au plan médian (88) pour le passage d'un rayon émis par un dispositif de sécurité composé d'une cellule photoélectrique émettrice et d'une cellule photoélectrique réceptrice.

9. Machine à scier selon la revendication 1, où le plateau tournant (42) comporte des tiges de centrage (149, 150) pour le positionnement des plaques (1) par rapport audit plateau tournant (42).

**Claims**

1. A machine for sawing commercialised products in the form of sheets, these sheets being of metal, wood, particulate materials or other similar materials, and formed to size by sawing from below, the machine comprising :

— a fixed main frame (34) provided with rails (28, 29) for the guidance of :

— a feed table (4), the position of which is variable perpendicularly with respect to the saw line (3), and comprising on the one hand, trains of rollers (6, 7, 8, 9) consisting of upper rollers ($6_1$, $7_1$, ...) and lower rollers ($6_2$, $7_2$, ...) mounted pivotally about a horizontal axis (10, 11, 12, 13) and carried by supports (14, 15, 16, 17) which are fixed to the feed table (4), the guide rails (28, 29) of the fixed main frame (34) being situated between the upper rollers ($6_1$, $7_1$ ...) and the lower rollers ($6_2$, $7_2$ ...) and, on the other hand, a bearing ring (55) carrying ball bearings (56, 57) in which a pivot (54) is rotatable

— an actuator (35), preferably hydraulic, subjecting the feed table (4) to a forward and retracting movement, one end of the actuator being fixed to a support (36) fixed on the main frame (34), and the end (37) of the piston (38) of the actuator being fixed to one of the ends of a coupling member (39) the other end of which is secured to the feed table (4) by a fixing element (40),

— adjusting means for the length of travel of the feed table (4), comprising, on the one hand the actuator (35) and, on the other hand, adjusting elements (41) allowing the end position of the piston (38) of the actuator (35) with respect to the coupling member (39) to be modified,

— a turntable (42) rotatable with a support disc (45) and fixed thereto by a dowel (104) which is engaged on the one hand in a hole (105) formed in the turntable (42) and, on the other hand, in a hole (106) formed in the support disc (45), the latter being fixed for rotation with the pivot (54) rotatable in the bearing ring (55) of the feed table (4),

— a control system for causing the automatic rotation of the turntable (42) through a quarter turn, this control system being activated by the retraction of the feed table (4), and being provided with an indexing cam (60) fixed for rotation with the lower end (58) of the pivot (54), this indexing cam (60) having a square surface, whith its four corners (61, 62, 63, 64) being provided with projections (65, 66, 67, 68), each of which has a form approximating to a rectangular trapezuim, the small side (69) of the trapezium, forming an extension of one of the sides (70) of the corner (61, 62, 63, 64), and the side (71) of the trapezuim perpendicular to the small side (69) being connected to the other side (72) of the corner (61, 62, 63, 64) through an inclined ramp (73).

2. A sawing machine according to Claim 1, in which the control device includes an indexing trigger (74) acting on one of the projections (65, 66, 67, 68) during retraction of the feed table (4), but being retractable during the advance of the said feed table (4) this indexing trigger (74) comprising, on the one hand, a lever (75), pivotable horizontally about a pivot pin (76) which is fixed to the fixed main frame (34) and disposed at one of the ends (77) of the lever (75), the other end of which (78) is provided with a roller (80) pivotable about a vertical axis (79) and cooperating with the projections (65, 66, 67, 68) of the indexing cam (60), and, on the other hand, a support (84) fixed to the main frame (34) and connected to the lever (75) through a resilient element (81) exerting a pulling force on the said lever (75) so as to maintain it in an active position, this support (84) having an adjustable element (85) opposing the retraction of the roller (80) during retraction of the feed table (4), the end (86) of this adjustable element (85) being in contact with the edge (87) of the lever (75) when the latter is in the active position.

3. A sawing machine according to Claim 1, comprising, for setting the angular position of the turntable (42) and for maintaining it in position during the advance of the feed table (4), a locking device (89) comprising, on the one hand a support (97) fixed to the upper face (22) of the feed table (4), having a horizontal housing (96) in which there slides a cylindrical body (94) of a stirrup (92) provided with a roller (92) pivotable about an axis (91), the cylindrical body (94) being surrounded by a bush (95) and having a longitudinal groove (100) in which engages the end (101) of a pin (102) extending through an orifice (103) formed in the bush (95) and preventing the rotation of the cylindrical body (94) and of the bush (95), and on the other hand, a resilient element (107), interposed between the base (109) of the housing (96) and the base (111) of a blind hole (112) which is formed in the cylindrical body (94), for ensuring the resilient return of the roller (90), the said support (97) comprising an adjusting element (113) for modifying the compression of the resilient element (107).

4. A sawing machine according to Claim 1, which the support disc (45) comprises on its circumference (118) V shaped notches (114, 115, 116, 117) disposed in pairs on two diameters (121, 122) which are perpendicular to each other and in which the roller (90) of the locking device (89) engages, each of these notches (114, 115, 116, 117) having two faces (119, 120) which are perpendicular to each other, so that the simultaneous cooperation of both of said faces with the roller (90) ensures the positioning and maintenance in position of the turntable (42).

5. A sawing machine according to Claim 1, in which the fixed main frame (34) comprises fine adjustment end stops (123, 124) against which the edge (125) of the turntable (42) comes into engagement, these fine adjustment end stops (123, 124) having, on the one hand, a horizontal rail (126) having a circular bore (132) greater in diameter than fixing elements (127, 128) which secure the fine adjustment end stops (123, 124) to the fixed main frame (34), and on the other hand, a vertically extending rib portion through which adjusting elements (134) extend horizontally for positioning the fine adjustment end stops (123, 124) with respect to the support (129), and therefore with respect to the saw line (3).

6. A sawing machine according to Claim 1, which comprises, for allowing the turntable (42) to be interchangeable, a locking device including, on the one hand, a cruciform housing (43) formed in the turntable (42) and having two shoulders (48, 49), and on the other hand, a locking latch (44) pivotable about a pivot axis (50) which is fixed to the support disc (45) of the turntable (42) this locking latch (44) having two wings (46, 47) the length of which is greater than the distance (51) between the edges (52, 53) of the shoulders (48, 49) and a width smaller than the distance (51) between the edges (52, 53) of the shoulders (48, 49).

7. A sawing machine according to Claim 1, which includes an automatic disposal device for waste matter, comprising an inclined ramp (137) fixed to a support (138), placed on the other side of the saw line (3).

8. A sawing machine according to Claim 1, in which the indexing cam (60) comprises on each side a slot (148) parallel to the median plane (88), for the passage therethrough of a beam emitted by a safety device comprising a photoelectric emitter cell and a photoelectric receiver cell.

9. A sawing machine according to Claim 1, in which the turntable (42) comprises centering pins (149, 150) for positioning sheets (1) with respect to the said turntable (42).

**Patentansprüche**

1. Maschine zum Sägen von Plattenumrissen aus Platten, die aus Metall, Holz oder einem ähnlichen Material bestehen und unterseitig zugeschnitten werden, gekennzeichnet durch
— ein festes Tragwerk (34), das mit Schienen (28, 29) versehen ist, die der Führung dienen für :
— einen veränderlich senkrecht zur Schneidelinie (3) verstellbaren Zuführtisch bestehend einerseits aus Rollkörperzügen (6, 7, 8, 9), die aus oberen und unteren Rollkörpern ($6_1$, $7_1$... bzw. $6_2$, $7_2$...) bestehen, die um eine horizontale Achse (10, 11, 12, 13) drehbar sind und von den am Zuführtisch (4) befestigten Halterungen (14, 15, 16, 17) gehalten werden, wobei die Führungsschienen (28, 29) des festen Tragwerks (34) zwischen den oberen und den unteren ($6_1$, $7_1$... bzw. $6_2$, $7_2$...) Rollkörpern liegen, und andererseits aus einem Kugelrollenlager (55, 56, 57), in dem ein Zapfen (54) drehbar liegt,
— ein vorzugsweise hydraulisches Stellglied (35), von dem der Zuführtisch (4) eine Vor- und Rückwärtsbewegung erfährt, wobei ein Ende mit der am Tragwerk (34) befestigten Halterung (36) und das Ende (37) des Kolbens (38) mit einem der Enden eines Schwingarms (39) verbunden ist, dessen anderes Ende durch ein Befestigungsteil (40) fest mit dem Zuführtisch (4) verbunden ist,
— Mittel zum Regeln des Laufs des Zuführtisches (4) bestehend einerseits aus dem Stellglied (35) und andererseits aus den Stellgliedern (41), durch die die Stellung des Kolbenendes (38) des Stellgliedes (35) gegenüber dem Schwingarm (39) verändert werden kann,
— eine Drehscheibe (42), die drehbar mit einem Flansch (45) verbunden ist, und zwar mittels einer Verbindungsachse (104), die einerseits in ein in der Drehscheibe (42) eingelassenem Loch (105) und andererseits in ein Loch (106) greift, das im Flansch (45) eingelassen ist, der drehbar mit dem Zapfen (54) verbunden ist, der sich im Lager (55) des Zuführtisches (4) drehend bewegt,
— eine Steuervorrichtung, durch die die selbsttätige Drehbewegung um eine Vierteldrehung der Drehscheibe (42) bewirkt wird, wobei die Steuervorrichtung durch das Rückfahren des Zuführtisches (4) betätigt wird, der mit einem drehfest mit dem unteren Ende (58) des Zapfens (54) verbundenen Indexierungsnocken (60) versehen ist, der eine quadratische Oberfläche besitzt, an deren vier Ecken (61, 62, 63, 64) die Anschläge (65, 66, 67, 68) von annähernd rechteckiger Trapezform liegen, deren kleine Seite (69), die in der Verlängerung einer der Seiten (70) der Ecke (61, 62, 63, 64) liegen, und deren senkrecht zur kleinen Seite (69) stehenden Seite (71) durch eine Neigungsfläche (73) mit der anderen Seite (72) der Ecke (61, 62, 63, 64) verbunden sind.

2. Maschine zum Sägen nach Anspruch 1, dadurch gekennzeichnet, daß die Steuervorrichtung einen Indexierungsstößel (74) aufweist, der beim Rückfahren des Zuführtisches (4) auf einen der Anschläge (65, 66, 67, 68) einwirkt, sich jedoch beim Vorfahren des Zuführtisches (4) rückstellt, wobei der Indexierungsstößel (74) einerseits einen Hebel (75), der horizontal um eine Drehachse (76) drehbar ist, die mit dem festen Tragwerk (34) verbunden ist und die an einem der Enden (77) des Hebels (75) liegt, dessen anderes Ende (78) mit einem Rollkörper (80) versehen ist, der sich um eine senkrechte Achse (79) dreht und mit den Anschlägen (65, 66, 67, 68) des Indexierungsnockens (60) zusammenarbeitet, und andererseits eine Halterung (84) aufweist, die mit dem Tragwerk (34) fest verbunden ist und über ein elastisches Glied (81) am Hebel (75) liegt, das auf diesen Hebel (75) einen Zug ausübt, um ihn in Betätigungsstellung zu halten, und wobei diese Halterung (84) ein Regelglied (85) aufweist, das sich beim Rückfahren des Zuführtisches (4) dem Rückstellen des Rollkörpers (80) widersetzt und dessen Ende (86) dann mit der Kante (87) des Hebels (75) in Kontakt steht, wenn sich dieser in Betätigungsstellung befindet.

3. Maschine zum Sägen nach Anspruch 1, dadurch gekennzeichnet, daß sie zur Winkelpositionierung der Drehscheibe (42) und zur Aufrechterhaltung der Stellung beim Vorschieben des Zuführtisches (4) über eine Blockiervorrichtung (89) verfügt, die sich zusammensetzt einerseits aus einer Halterung (97), die an der oberen Seite (22) des Zuführtisches (4) befestigt ist, wodurch eine horizontale Lagerung (96) gegeben ist, in der ein zylinderförmiger Körper (94) eines mit einem um eine Achse (91) sich drehenden Rollenkörpers (90) versehenen Kopfes (92) gleitend geführt wird und der zylinderförmige Körper (94) von einer Büchse (95) umgeben ist, die einen Längsschlitz (100) aufweist, in den das Ende (101) einer Achse (102) eingreift, die eine Öffnung (103) durchläuft, die in der Büchse (95) eingelassen ist und die Drehbewegung des zylinderförmigen Körpers (94) und der Büchse (95) aufhebt, und andererseits aus einem elastischen Glied (107), das zwischen dem Boden (109) der Lagerung (96) und dem Boden (111) eines Sacklochs (112) angeordnet ist, das im zylinderförmigen Körper (94) eingelassen ist und ein elastisches Rückholen des Rollkörpers (90) gewährleistet, wobei die Halterung (97) zum Verändern der Pressung des elastischen Gliedes (107) ein Regelglied (113) aufweist.

4. Maschine zum Sägen nach Anspruch 1, dadurch gekennzeichnet, daß der Flansch (45) auf seinem Umfang (118) Einkerbungen in « V »-Form (114, 115, 116, 117) aufweist, die paarweise auf zwei Durchmesser (121, 122) senkrecht zueinander angeordnet sind und in die der Rollkörper (90) der Blockiervorrichtung (89) eingreift, wobei die Einkerbungen (114, 115, 116, 117) zwei senkrecht zueinander stehende Flügel (119, 120) besitzt, durch deren gleichzeitiges Zusammenarbeiten mit dem Rollkörper (90) die Positionierung und die Positionshaltung der Drehscheibe (42) gewährleistet wird.

5. Maschine zum Sägen nach Anspruch 1, dadurch gekennzeichnet, daß das feste Tragwerk (34) Präzisionsanschläge (123, 124) besitzt, an die die Kante (125) der Drehscheibe (42) anschlagen und die einerseits eine horizontale Leiste (126) darstellen, die eine Bohrung (132) bietet, die größer ist als der Durchmesser der Befestigungsteile (127, 128), durch die die Präzisionsanschläge (123, 124) mit dem festen Tragwerk (34) verbunden werden, und andererseits einen senkrechten Flügel (133) ergeben, der horizontal von den Regelgliedern (134) zur Positionierung der Präzisionsanschläge (123, 124) gegenüber der Halterung (129) und folglich auch gegenüber der Schneidelinie (3) durchlaufen wird.

6. Maschine zum Sägen nach Anspruch 1, dadurch gekennzeichnet, daß sie zur Ermöglichung der Austauschbarkeit der Drehscheibe (42) eine Verriegelungsvorrichtung besitzt, die einerseits eine Lagerung in Form eines Kreuzzapfens (43), der in der Drehscheibe (42) mit zwei Schultern oder Ansätzen (48, 49) ausgebildet ist, und andererseits eine Verriegelungsklinke (44) bietet, die um eine mit dem Flansch (45) der Drehscheibe (42) verbundene Drehachse (50) drehbar ist und zwei Flügel (46, 47) von einer Länge besitzt, die größer ist als die Enfernung (51), die die Kanten (52, 53) der Schultern oder Ansätze (48, 49) trennt, und eine Breite hat, die geringer ist als die Entfernung (51), die die Kanten (52, 53) der Schultern (48, 49) trennt.

7. Maschine zum Sägen nach Anspruch 1, gekennzeichnet durch eine Vorrichtung zum selbsttätigen Freigeben des Verschnitts, die aus einer Neigungsebene (137) besteht, die an einer auf der anderen Seite der Schneidlinie (3) angeordneten Halterung (138) liegt.

8. Maschine zum Sägen nach Anspruch 1, dadurch gekennzeichnet, daß der Indexierungsnocken (60) auf jeder Seite einen parallel zur medianen Ebene (88) liegenden Spalt (148) zum Hindurchlassen eines Strahls besitzt, der von einer Sicherheitsvorrichtung abgegeben wird, die aus einer photoelektrischen Emitterzelle und einer photoelektrischen Empfängerzelle besteht.

9. Maschine zum Sägen nach Anspruch 1, dadurch gekennzeichnet, daß die Drehscheibe (42) Zentrierstifte (149, 150) zum Positionieren der Platten (1) gegenüber der Drehscheibe (42) besitzt.

FIG. 1

FIG. 2

FIG. 3

FIG. 4

FIG. 5